(19) Europäisches Patentamt / European Patent Office / Office européen des brevets

(11) **EP 3 686 891 B1**

(12) **FASCICULE DE BREVET EUROPEEN**

(45) Date de publication et mention
de la délivrance du brevet:
**10.11.2021 Bulletin 2021/45**

(51) Int Cl.:
*G11C 13/00* *(2006.01)*       *H01L 45/00* *(2006.01)*

(21) Numéro de dépôt: **19214351.9**

(22) Date de dépôt: **09.12.2019**

(54) **CELLULE MEMOIRE RESISTIVE A BASE D'OXYDE OXRAM ET PROCEDE DE FABRICATION ASSOCIE**

RESISTIVE SPEICHERZELLE AUF OXRAMOXID-BASIS UND ENTSPRECHENDES HERSTELLUNGSVERFAHREN

RESISTIVE MEMORY CELL WITH OXRAM OXIDE AND ASSOCIATED MANUFACTURING METHOD

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **14.12.2018 FR 1872909**

(43) Date de publication de la demande:
**29.07.2020 Bulletin 2020/31**

(73) Titulaire: **Commissariat à l'Energie Atomique et aux Energies Alternatives
75015 Paris (FR)**

(72) Inventeurs:
• **GASSILLOUD, Rémy**
**38054 GRENOBLE CEDEX 09 (FR)**
• **BERNARD, Mathieu**
**38054 GRENOBLE CEDEX 09 (FR)**
• **CHARPIN-NICOLLE, Christelle**
**38054 GRENOBLE CEDEX 09 (FR)**

(74) Mandataire: **Cabinet Camus Lebkiri
25 rue de Maubeuge
75009 Paris (FR)**

(56) Documents cités:
**US-A1- 2013 126 821**

• **WOO JIYONG ET AL: "8-inch wafer-scale HfOx-based RRAM for 1S-1R cross-point memory applications", 2014 14TH ANNUAL NON-VOLATILE MEMORY TECHNOLOGY SYMPOSIUM (NVMTS), IEEE, 27 octobre 2014 (2014-10-27), pages 1-4, XP032747411, DOI: 10.1109/NVMTS.2014.7060853 ISBN: 978-1-4799-4203-9 [extrait le 2015-03-13]**

**Description**

**DOMAINE TECHNIQUE**

La présente invention est relative à une cellule mémoire résistive à base d'oxyde OxRAM (de l'anglais « oxide-based resistive random access memory ») ainsi qu'à un procédé de fabrication d'une telle cellule.

**ÉTAT DE LA TECHNIQUE**

D'une manière générale, une cellule OxRAM est formée d'un empilement d'une première couche métallique, une couche d'isolant et une seconde couche métallique, notée métal-isolant-métal ou « MIM ». De manière standard, la première couche métallique est une électrode inférieure en nitrure de titane TiN, sur laquelle est déposée la couche d'isolant en dioxyde d'hafnium $HfO_2$, typiquement de 10 nm d'épaisseur, et la seconde couche métallique comporte une couche de titane Ti, typiquement de 10 nm d'épaisseur, déposée sur la couche d'isolant, et une électrode supérieure en nitrure de titane TiN déposée sur la couche de titane Ti.

Dans une telle structure, l'équilibre thermodynamique est réalisé par migration d'une partie de l'oxygène contenu dans la couche d'isolant en dioxyde d'hafnium $HfO_2$ vers la couche de titane Ti située juste au-dessus, l'oxygène étant en position interstitielle dite «$\alpha$-Ti» du titane métallique, de sorte que le dioxyde d'hafnium $HfO_2$ stœchiométrique devient du dioxyde d'hafnium $HfO_{z<2}$ sous-stœchiométrique. Le fait que le dioxyde d'hafnium $HfO_{z<2}$ sous-stœchiométrique présente des lacunes en oxygène par rapport au dioxyde d'hafnium stœchiométrique $HfO_2$ permet de faciliter la formation d'un filament au sein de la cellule OxRAM, et notamment la première formation d'un filament lors de l'étape de forming.

Il est souhaitable de pouvoir contrôler le taux de lacune d'oxygène de l'isolant, mais il n'est pas possible de déposer directement une couche de dioxyde d'hafnium $HfO_{z<2}$ sous-stœchiométrique avec un taux contrôlé de lacune d'oxygène. En effet, lorsqu'on cherche à introduire de l'oxygène dans une couche d'hafnium, le premier composé stable que l'on obtient est directement du dioxyde d'hafnium $HfO_2$. Pour contrôler le taux de lacune d'oxygène de l'isolant, il est donc connu de travailler sur un empilement d'une couche d'hafnium Hf sur une couche de dioxyde d'hafnium $HfO_2$ stœchiométrique. L'équilibre thermodynamique se réalise de la même manière que précédemment, par migration d'une partie de l'oxygène contenu dans la couche d'isolant en dioxyde d'hafnium $HfO_2$ vers la couche d'hafnium Hf située juste au-dessus, l'oxygène étant en position interstitielle dite «$\alpha$-Hf» de l'hafnium métallique, de sorte que le dioxyde d'hafnium $HfO_2$ stœchiométrique devient du dioxyde d'hafnium $HfO_{z<2}$ sous-stœchiométrique. Une contrainte de cet empilement est que la couche supérieure d'hafnium Hf ne doit pas être exposée à l'air sous peine d'oxydation immédiate de l'hafnium Hf en dioxyde d'hafnium $HfO_2$. Il est donc nécessaire de protéger la couche supérieure d'hafnium Hf en la recouvrant in situ, en atmosphère contrôlée, par l'électrode supérieure. Cela requiert toutefois un équipement particulier donc onéreux.

Pour s'affranchir de cette contrainte, on voudrait pouvoir travailler sur un empilement d'une couche de dioxyde d'hafnium $HfO_2$ sur une couche d'hafnium Hf, mais ce n'est pas possible car le dépôt du dioxyde d'hafnium $HfO_2$ s'effectue dans une atmosphère oxydante, qui transforme immédiatement l'hafnium Hf en dioxyde d'hafnium $HfO_2$. Plus généralement, on souhaiterait obtenir un isolant présentant un gradient en oxygène dans son épaisseur avec une déplétion en oxygène localisée du côté de l'électrode inférieure, car cela favoriserait la localisation des phénomènes de diffusion d'oxygène à distance d'une potentielle oxydation superficielle.

Les documents de l'art antérieur US2013/126821 A1 et *"8-inch wafer-scale $HfO_x$-based RRAM for 1S-1R cross-point memory applications"*, Jiyong Woo et al., 14th Annual Non-Volatile Memory Technology Symposium (NVMTS), IEEE, 2014-10-27, divulguent des cellules mémoires résistives à base d'oxyde.

**RÉSUMÉ DE L'INVENTION**

On constate qu'il existe un besoin de contrôler, dans une structure OxRAM comportant un isolant à base d'oxyde de métal de transition, le taux de lacune d'oxygène de l'isolant, ou autrement dit la quantité résiduelle d'oxygène de l'isolant, d'une manière plus économique que dans l'état de la technique. On constate également qu'il existe un besoin de favoriser la localisation des phénomènes de diffusion d'oxygène d'une cellule OxRAM comportant un isolant à base d'oxyde de métal de transition du côté de l'électrode inférieure, à distance d'une potentielle oxydation superficielle.

Selon un premier aspect de l'invention, on tend à satisfaire ce besoin en proposant une cellule mémoire résistive à base d'oxyde OxRAM comportant une couche d'isolant agencée entre une première couche métallique et une seconde couche métallique, dans laquelle :

- la première couche métallique est une première électrode ;

- la couche d'isolant est une couche M1Oss d'un oxyde sous-stœchiométrique d'un premier métal M1 ;

- la deuxième couche métallique comporte, dans cet ordre depuis la couche d'isolant :

   o une première sous-couche M2N d'un nitrure d'un deuxième métal M2 ;

   o une deuxième sous-couche M3M4O d'un alliage ternaire d'un troisième métal M3, d'un quatrième métal M4 et d'oxygène O, ou M3M4NO d'un alliage quaternaire du troisième métal M3, du quatrième métal M4, d'azote N et d'oxygène O ;

   o une seconde électrode ;

les premier, deuxième, troisième et quatrième métaux M1, M2, M3 et M4 étant choisis de manière que l'enthalpie libre standard de formation de l'alliage ternaire M3M4O, notée $\Delta G_{f,T}^0(M3M4O)$, ou de l'alliage quaternaire M3M4NO, notée $\Delta G_{f,T}^0(M3M4NO)$, soit strictement inférieure à l'enthalpie libre standard de formation de l'oxyde sous-stœchiométrique M1Oss du premier métal M1, notée $\Delta G_{f,T}^0(M1Oss)$, elle-même inférieure ou égale à l'enthalpie libre standard de formation de tout oxynitrure ternaire M2NO du deuxième métal M2, notée $\Delta G_{f,T}^0(M2NO)$ :

$$\Delta G_{f,T}^0(M3M4O) < \Delta G_{f,T}^0(M1Oss) \leq \Delta G_{f,T}^0(M2NO)$$

$$ou\ \Delta G_{f,T}^0(M3M4NO) < \Delta G_{f,T}^0(M1Oss) \leq \Delta G_{f,T}^0(M2NO)$$

D'une manière générale, dans la présente demande, les formules chimiques génériques, c'est-à-dire faisant intervenir les premier, deuxième, troisième et/ou quatrième métaux M1, M2, M3 et/ou M4, ne précisent pas la quantité d'atomes de chaque élément présent dans le composé, afin d'alléger les notations et de gagner en lisibilité et en clarté. Dans la suite, toujours dans un objectif d'allègement des notations, les exemples particuliers de composés ternaires et quaternaires décrits par la suite ne précisent pas non plus la quantité d'atomes de chaque élément présent dans ledit composé ternaire ou quaternaire ; seuls les exemples particuliers de composés binaires précisent la quantité d'atomes de chaque élément présent dans ledit composé binaire.

La couche d'isolant M1Oss est sous-stœchiométrique car selon la condition thermodynamique ci-dessus, une partie de son oxygène migre vers la deuxième sous-couche M3M4O ou M3M4NO à travers la première sous-couche M2N, entraînant la formation d'un gradient d'oxygène dans la couche d'isolant M1Oss, avec une déplétion en oxygène située du côté de la première électrode. Un oxynitrure ternaire M2NO du deuxième métal M2 se forme de manière transitoire dans la première sous-couche, au cours de la migration d'oxygène depuis la couche d'isolant vers la deuxième sous-couche. Par ailleurs, on observe expérimentalement que la part d'oxygène piégée dans l'alliage M3M4O ou M3M4NO de la deuxième sous-couche ne retourne pas dans l'isolant. Une explication possible est que l'oxygène de l'alliage M3M4O ou M3M4NO n'est pas en position interstitielle comme dans les empilements de l'art antérieur mais forme des liaisons, ce qui contribue à fixer l'oxygène dans l'alliage ; et que l'équilibre thermodynamique entre la deuxième sous-couche M3M4O ou M3M4NO et la couche d'isolant est par ailleurs rompu par la première sous-couche M2N du nitrure du deuxième métal M2. D'une manière générale :

- l'enthalpie libre standard de formation $\Delta G_{f,T}^0(M3M4O)$ de l'alliage ternaire M3M4O est associée à l'équation chimique suivante, pour tout y :

$$\frac{2}{y}M3M4 + O_2 \xrightarrow{\Delta G_{f,T}^0(M3M4O)} \frac{2}{y}M3M4O_y$$

- l'enthalpie libre standard de formation $\Delta G_{f,T}^0(M3M4NO)$ de l'alliage quaternaire M3M4NO est associée à l'équation chimique suivante, pour tout y:

$$\frac{2}{y} M3M4N + O_2 \xrightarrow{\Delta G_{f,T}^0(M3M4O)} \frac{2}{y} M3M4NO_y$$

- l'enthalpie libre standard de formation $\Delta G_{f,T}^0(M1Oss)$ de l'oxyde sous-stœchiométrique M1Oss du premier métal M1 est associée à l'équation chimique suivante, pour tout z :

$$\frac{2}{z} M1 + O_2 \xrightarrow{\Delta G_{f,T}^0(M1Oss)} \frac{2}{z} M1O_z$$

- l'enthalpie libre standard de formation $\Delta G_{f,T}^0(M2NO)$ de tout oxynitrure ternaire M2NO du deuxième métal M2 est associée à l'équation chimique suivante, pour tout w :

$$\frac{2}{w} M2N + O_2 \xrightarrow{\Delta G_{f,T}^0(M2NO)} \frac{2}{w} M2NO_w$$

La cellule mémoire résistive à base d'oxyde OxRAM selon le premier aspect de l'invention peut également présenter une ou plusieurs des caractéristiques ci-dessous, considérées individuellement ou selon toutes les combinaisons techniquement possibles :

Selon un mode de réalisation, la cellule mémoire résistive à base d'oxyde OxRAM comporte en outre une couche réservoir en titane Ti, intercalée entre la couche d'isolant et la première sous-couche M2N du nitrure du deuxième métal M2 de la deuxième couche métallique. La couche réservoir en titane Ti, en contact avec la couche d'isolant, permet de stocker ou de libérer de l'oxygène au cours des cycles de fonctionnement de la mémoire.

Selon un mode de réalisation, le quatrième métal M4 présente une faible solubilité à l'oxygène par rapport au troisième métal M3. Plus précisément, le quatrième métal M4 présente une solubilité à l'oxygène inférieure à une solubilité à l'oxygène du troisième métal M3. La solubilité à l'oxygène d'un métal désigne la proportion d'oxygène pouvant être stockée dans le métal sous forme interstitielle non liée (c'est-à-dire sans liaison M-O ; par proportion, on désigne par exemple le nombre moyen d'atomes d'oxygène par atome de métal). Ainsi, le pourcentage atomique du quatrième métal M4 dans l'alliage M3M4O ou M3M4NO permet de contrôler la solubilité à l'oxygène du troisième métal M3 et d'éviter la réduction totale de l'oxygène de la couche d'isolant. En effet, plus le pourcentage atomique du quatrième métal M4 est grand, dans le mélange M4/M3, et plus la solubilité à l'oxygène du troisième métal M3 diminue. La présence du quatrième métal M4 (Al ou Si, par exemple) réduit la capacité du troisième métal M3 (Titane par exemple) à absorber en volume de l'oxygène, car le quatrième métal M4 produit un effet comparable à ce qui serait obtenu si la surface du troisième M3 était passivée. Ainsi, lorsque l'alliage M4/M3 est mis au contact (directement ou non) avec la couche d'isolant (couche « active » de la mémoire, par exemple de SiO2, ou de HfO2, et qui comprend nécessairement de l'oxygène), la présence du quatrième métal M4 permet d'éviter le transfert complet de l'oxygène de la couche d'isolant vers la couche comprenant le troisième métal M3. En absence du quatrième métal M4, la couche comprenant le troisième métal M3 pourrait absorber une grande partie de l'oxygène contenu dans la couche d'isolant, ce qui lui ferait perdre une partie de sa nature isolante.

Selon un mode de réalisation, les premier, deuxième, troisième et quatrième métaux M1, M2, M3 et M4 sont choisis parmi les éléments de transition des groupes 4, 5 et 6 du tableau périodique et les éléments silicium Si et aluminium Al ; les premier et deuxième métaux M1 et M2 étant identiques ou distincts et les deuxième et troisième métaux M2 et M3 étant identiques ou distincts mais les premier, deuxième et troisième métaux M1, M2 et M3 n'étant pas tous identiques ; et les troisième et quatrième métaux M3 et M4 étant distincts.

Selon un mode de réalisation, les premier, deuxième, troisième et quatrième métaux M1, M2, M3 et M4 sont choisis parmi les éléments hafnium Hf, zirconium Zr, titane Ti, tantale Ta, niobium Nb, vanadium V, tungstène W, molybdène Mo, silicium Si et aluminium Al.

Selon un mode de réalisation, l'oxyde sous-stœchiométrique du premier métal M1 est du dioxyde d'hafnium $HfO_{z<2}$ ou du dioxyde de zirconium $ZrO_{z<2}$ ou du dioxyde de titane $TiO_{z<2}$ ou du pentoxyde de tantale $Ta_2O_{z<5}$ ou du dioxyde de vanadium $VO_{z<2}$ ou du pentoxyde de vanadium $V_2O_{z<5}$ ou de l'oxyde de tungstène $WO_{z<1}$ ou du dioxyde de tungstène $WO_{z<2}$ ou du trioxyde de tungstène $WO_{z<3}$ ou de l'oxyde d'aluminium $Al_2O_{z<3}$ ou du dioxyde de silicium $SiO_{z<2}$.

Selon un mode de réalisation, le nitrure du deuxième métal M2 est du nitrure de titane TiN ou du nitrure de tantale TaN ou du nitrure de zirconium ZrN ou du nitrure d'hafnium HfN ou du nitrure de tungstène WN ou du nitrure de vanadium VN ou du carbonitrure de titane TiCN ou du carbonitrure de tantale TaCN ou du carbonitrure de molybdène MoCN, ou du carbonitrure de tungstène WCN.

Selon un mode de réalisation, l'alliage ternaire M3M4O est un alliage ternaire de :

- titane Ti, aluminium Al et oxygène O, ou

- titane Ti, silicium Si et oxygène O, ou

- zirconium Zr, aluminium Al et oxygène O, ou

- zirconium Zr, silicium Si et oxygène O, ou

- hafnium Hf, aluminium Al et oxygène O, ou

- hafnium Hf, silicium Si et oxygène O ;

et l'alliage quaternaire M3M4NO est un alliage quaternaire de :

- titane Ti, aluminium Al, azote N et oxygène O, ou

- titane Ti, silicium Si, azote N et oxygène O, ou

- zirconium Zr, aluminium Al, azote N et oxygène O, ou

- zirconium Zr, silicium Si, azote N et oxygène O, ou

- hafnium Hf, aluminium Al, azote N et oxygène O, ou

- hafnium Hf, silicium Si et, azote N oxygène O.

Selon un mode de réalisation, la deuxième sous-couche d'alliage ternaire M3M4O ou d'alliage quaternaire M3M4NO comporte une proportion du troisième métal M3 de (1-x) et une proportion du quatrième métal M4 de x, où x appartient à l'intervalle [1% ; 60%], préférentiellement [5% ; 50%], préférentiellement [10% ; 40%]. Ainsi, la quantité du quatrième métal M4 dans la deuxième sous-couche pilote le résiduel et le gradient d'oxygène dans l'isolant, tout en maintenant une part d'oxygène suffisamment faible dans l'alliage M3M4O ou M3M4NO pour qu'il conserve ses propriétés de conduction.

Selon un mode de réalisation, x est égal à 30%.

Selon un mode de réalisation, la couche M1Oss d'oxyde sous-stœchiométrique du premier métal est d'épaisseur comprise dans l'intervalle [1 nm ; 15 nm] et préférentiellement 10 nm.

Selon un mode de réalisation, la première sous-couche M2N de nitrure du deuxième métal est d'épaisseur comprise dans l'intervalle [2 nm ; 20 nm] et préférentiellement 5 nm.

Selon un mode de réalisation, la deuxième sous-couche d'alliage ternaire M3M4O ou d'alliage quaternaire M3M4NO est d'épaisseur comprise dans l'intervalle [1 nm ; 50 nm] et préférentiellement 20 nm. L'épaisseur de la deuxième sous-couche contribue à déterminer la quantité du quatrième métal M4 et donc à piloter le résiduel et le gradient d'oxygène dans l'isolant, tout en maintenant une part d'oxygène suffisamment faible dans l'alliage M3M4O ou M3M4NO pour qu'il conserve ses propriétés de conduction.

Un deuxième aspect de l'invention concerne un procédé de fabrication d'une cellule mémoire résistive à base d'oxyde OxRAM selon le premier aspect de l'invention, comportant les étapes suivantes, dans cet ordre :

a) déposer une première électrode ;
b) déposer une couche M1O d'un oxyde stœchiométrique d'un premier métal M1 ;
c) déposer une couche M2N d'un nitrure d'un deuxième métal M2 ;
d) déposer une couche M3M4 d'un alliage binaire d'un troisième métal M3 et d'un quatrième métal M4, ou M3M4N d'un alliage ternaire du troisième métal M3, du quatrième métal M4 et d'azote N ;
e) déposer une seconde électrode ;

les premier, deuxième, troisième et quatrième métaux M1, M2, M3 et M4 étant choisis de manière que l'enthalpie libre standard de formation de tout alliage ternaire M3M4O des troisième et quatrième métaux M3, M4 et d'oxygène O, notée

$\Delta G_{f,T}^0(M3M4O)$ , ou de tout alliage quaternaire M3M4NO des troisième et quatrième métaux M3, M4, d'azote N et d'oxygène O, notée $\Delta G_{f,T}^0(M3M4NO)$ , soit strictement inférieure à l'enthalpie libre standard de formation de tout oxyde sous-stœchiométrique M1Oss du premier métal M1, notée $\Delta G_{f,T}^0(M1Oss)$ , elle-même inférieure ou égale à l'enthalpie libre standard de formation de tout oxynitrure ternaire M2NO du deuxième métal M2, notée $\Delta G_{f,T}^0(M2NO)$ :

$$\Delta G_{f,T}^0(M3M4O) < \Delta G_{f,T}^0(M1Oss) \leq \Delta G_{f,T}^0(M2NO)$$

$$ou\ \Delta G_{f,T}^0(M3M4NO) < \Delta G_{f,T}^0(M1Oss) \leq \Delta G_{f,T}^0(M2NO)$$

Dans le cadre de la présente demande, on note « M1Oss » l'oxyde sous-stœchiométrique du premier métal M1 et « M1O » l'oxyde stœchiométrique du premier métal M1. On entend par « oxyde stœchiométrique » un oxyde stable, c'est-à-dire qui pris individuellement existe à l'équilibre. Par opposition, on entend par « oxyde sous-stœchiométrique » un oxyde instable, c'est-à-dire qui pris individuellement n'existe pas à l'équilibre, et ne peut exister qu'au sein d'un équilibre thermodynamique établi avec d'autres composés.

Selon la condition thermodynamique ci-dessus, une partie de l'oxygène de la couche M1O d'oxyde stœchiométrique du premier métal M1 migre spontanément vers la couche d'alliage M3M4 ou M3M4N à travers la couche M2N de nitrure du deuxième métal M2. La couche M1O d'oxyde du premier métal M1 devient sous-stœchiométrique M1Oss et la couche d'alliage M3M4 ou M3M4N devient une couche d'alliage M3M4O ou M3M4NO. L'empilement initial évolue spontanément vers son équilibre thermodynamique et donne la cellule mémoire résistive à base d'oxyde OxRAM selon le premier aspect de l'invention. La réaction thermodynamique peut s'initier à température ambiante ou éventuellement sous assistance thermique. L'établissement de l'équilibre thermodynamique se fait typiquement de manière quasi-immédiate, en un temps de l'ordre de la seconde ou inférieur à la seconde, ou au maximum dans le temps de fabrication d'un dispositif microélectronique comportant la cellule mémoire selon l'invention, c'est-à-dire typiquement en un temps de l'ordre de l'heure, par exemple deux heures. L'intégration d'une cellule mémoire selon l'invention dans une ligne de cuivre d'un dispositif microélectronique lui impose typiquement un budget thermique de 400°C pendant plusieurs heures. La température maximum, à ne pas dépasser, est typiquement définie par la dégradation des lignes de cuivre ou siliciure dans les sources/drains des transistors.

Le procédé de fabrication selon le deuxième aspect de l'invention peut également présenter une ou plusieurs des caractéristiques ci-dessous, considérées individuellement ou selon toutes les combinaisons techniquement possibles :

Selon un mode de réalisation, le procédé de fabrication comporte, entre les étapes b) et c), une étape b') selon laquelle on dépose une couche réservoir en titane Ti sur la couche M1O d'oxyde stœchiométrique du premier métal M1.

Selon un mode de réalisation, le quatrième métal M4 a une solubilité à l'oxygène inférieure à la solubilité à l'oxygène du troisième métal M3. Le quatrième métal M4 peut d'ailleurs avoir une solubilité à l'oxygène sensiblement nulle, par exemple inférieure à 3%, voire inférieure à 1%, à température ambiante (20 degrés Celsius).

Selon un mode de réalisation, les premier, deuxième, troisième et quatrième métaux M1, M2, M3 et M4 sont choisis parmi les éléments de transition des groupes 4, 5 et 6 du tableau périodique et les éléments silicium Si et aluminium Al ; les premier et deuxième métaux M1 et M2 étant identiques ou distincts et les deuxième et troisième métaux M2 et M3 étant identiques ou distincts mais les premier, deuxième et troisième métaux M1, M2 et M3 n'étant pas tous identiques ; et les troisième et quatrième métaux M3 et M4 étant distincts.

Selon un mode de réalisation, les premier, deuxième, troisième et quatrième métaux M1, M2, M3 et M4 sont choisis parmi les éléments hafnium Hf, zirconium Zr, titane Ti, tantale Ta, niobium Nb, vanadium V, tungstène W, molybdène Mo, silicium Si et aluminium Al.

Selon un mode de réalisation, l'oxyde stœchiométrique du premier métal M1 est du dioxyde d'hafnium $HfO_2$ ou du dioxyde de zirconium $ZrO_2$ ou du dioxyde de titane $TiO_2$ ou du pentoxyde de tantale $Ta_2O_5$ ou du dioxyde de vanadium $VO_2$ ou du pentoxyde de vanadium $V_2O_5$ ou de l'oxyde de tungstène $WO_1$ ou du dioxyde de tungstène $WO_2$ ou du trioxyde de tungstène $WO_3$ ou de l'oxyde d'aluminium $Al_2O_3$ ou du dioxyde de silicium $SiO_2$.

Selon un mode de réalisation, le nitrure du deuxième métal M2 est du nitrure de titane TiN ou du nitrure de tantale TaN ou du nitrure de zirconium ZrN ou du nitrure d'hafnium HfN ou du nitrure de tungstène WN ou du nitrure de vanadium VN ou du carbonitrure de titane TiCN ou du carbonitrure de tantale TaCN ou du carbonitrure de molybdène MoCN, ou du carbonitrure de tungstène WCN

Selon un mode de réalisation, l'alliage binaire M3M4 est un alliage binaire de :

- titane Ti et aluminium Al, ou

- titane Ti et silicium Si, ou

- zirconium Zr, aluminium Al, ou

- zirconium Zr, silicium Si, ou

- hafnium Hf, aluminium Al, ou

- hafnium Hf, silicium Si ;

et l'alliage ternaire M3M4N est un alliage ternaire de :

- titane Ti, aluminium Al, et azote N, ou

- titane Ti, silicium Si, et azote N, ou

- zirconium Zr, aluminium Al, et azote N, ou

- zirconium Zr, silicium Si, et azote N, ou

- hafnium Hf, aluminium Al, et azote N, ou

- hafnium Hf, silicium Si et, et azote N.

Selon un mode de réalisation, la couche d'alliage binaire M3M4 ou d'alliage ternaire M3M4N comporte une proportion du troisième métal M3 de (1-x) et une proportion du quatrième métal M4 de x, où x appartient à l'intervalle [1% ; 60%], préférentiellement [5% ; 50%], préférentiellement [10% ; 40%].

Selon un mode de réalisation, x est égal à 30%.

Selon un mode de réalisation, la couche M1O d'oxyde stœchiométrique du premier métal est d'épaisseur comprise dans l'intervalle [1 nm ; 15 nm] et préférentiellement 10 nm.

Selon un mode de réalisation, la couche M2N de nitrure du deuxième métal est d'épaisseur comprise dans l'intervalle [2 nm ; 20 nm] et préférentiellement 5 nm.

Selon un mode de réalisation, la couche d'alliage ternaire M3M4O ou d'alliage quaternaire M3M4NO est d'épaisseur comprise dans l'intervalle [1 nm ; 50 nm] et préférentiellement 20 nm.

## BRÈVE DESCRIPTION DES FIGURES

D'autres caractéristiques et avantages de l'invention ressortiront clairement de la description qui en est donnée ci-dessous, à titre indicatif et nullement limitatif, en référence aux figures annexées, parmi lesquelles :

La figure 1a montre schématiquement un diagramme des étapes d'un premier procédé de fabrication d'une cellule mémoire résistive à base d'oxyde OxRAM selon un aspect de l'invention.

La figure 1b montre schématiquement la cellule mémoire résistive à base d'oxyde OxRAM hors équilibre thermodynamique, obtenue de manière transitoire immédiatement après les différentes étapes de dépôt du procédé de la figure 1a.

La figure 1c montre schématiquement la cellule mémoire résistive à base d'oxyde OxRAM de la figure 1b ayant atteint son équilibre thermodynamique.

La figure 2a montre schématiquement un diagramme des étapes d'un deuxième procédé de fabrication d'une cellule mémoire résistive à base d'oxyde OxRAM selon un aspect de l'invention.

La figure 2b montre schématiquement la cellule mémoire résistive à base d'oxyde OxRAM hors équilibre thermodynamique, obtenue de manière transitoire immédiatement après les différentes étapes de dépôt du procédé de la figure 2a.

La figure 2c montre schématiquement la cellule mémoire résistive à base d'oxyde OxRAM de la figure 2b ayant atteint son équilibre thermodynamique.

La figure 3a montre schématiquement un diagramme des étapes d'un troisième procédé de fabrication d'une cellule mémoire résistive à base d'oxyde OxRAM selon un aspect de l'invention.

La figure 3b montre schématiquement la cellule mémoire résistive à base d'oxyde OxRAM hors équilibre thermodynamique, obtenue de manière transitoire immédiatement après les différentes étapes de dépôt du procédé de la figure 3a.

La figure 3c montre schématiquement la cellule mémoire résistive à base d'oxyde OxRAM de la figure 3b ayant atteint son équilibre thermodynamique.

Pour plus de clarté, les éléments identiques ou similaires sont repérés par des signes de référence identiques sur l'ensemble des figures.

## DESCRIPTION DÉTAILLÉE D'AU MOINS UN MODE DE RÉALISATION

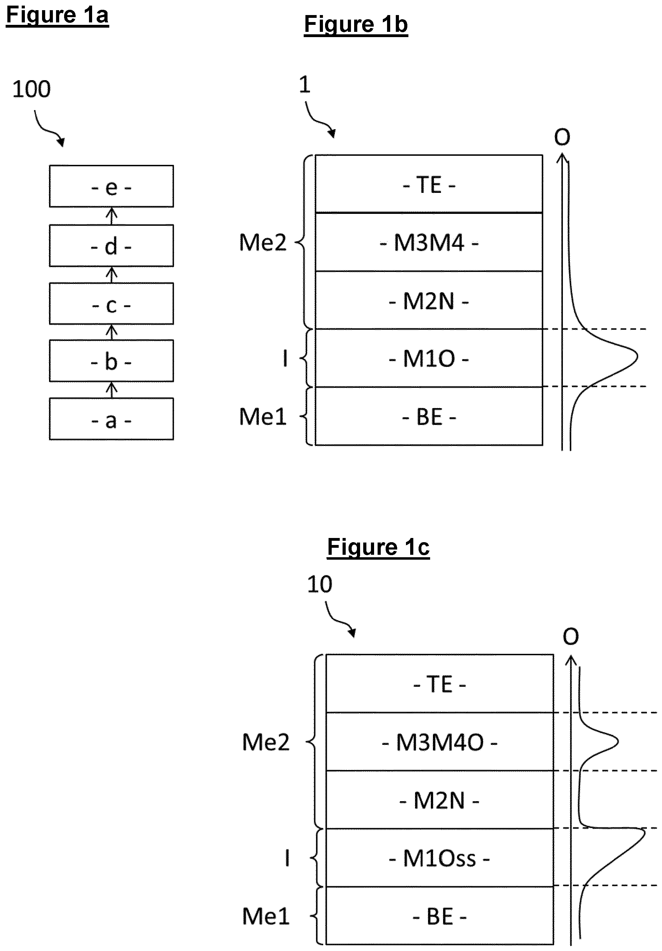

La figure 1a montre schématiquement un diagramme des étapes d'un premier procédé de fabrication 100 d'une cellule mémoire résistive à base d'oxyde OxRAM 10 selon un premier mode de réalisation de l'invention. La figure 1b montre schématiquement la cellule mémoire résistive à base d'oxyde OxRAM 1 hors équilibre thermodynamique, obtenue de manière transitoire immédiatement après les différentes étapes de dépôt du procédé 100 de la figure 1a. La figure 1c montre schématiquement la cellule mémoire résistive à base d'oxyde OxRAM 10 ayant atteint son équilibre thermodynamique. Les figures 1a, 1b et 1c sont décrites conjointement.

Le premier procédé de fabrication 100 comporte une première étape a) selon laquelle on dépose une première électrode ou électrode inférieure BE, par exemple en nitrure de titane TiN ou tout autre métal neutre vis-à-vis de l'oxygène, typiquement sur un substrat (non représenté) ; puis une deuxième étape b) selon laquelle on dépose une couche M1O d'un oxyde stœchiométrique d'un premier métal M1 sur la première électrode BE ; puis une troisième étape c) selon laquelle on dépose une couche M2N d'un nitrure d'un deuxième métal M2 sur la couche M1O ; puis une quatrième étape d) selon laquelle on dépose une couche M3M4 d'un alliage binaire d'un troisième métal M3 et d'un quatrième métal M4 sur la couche M2N ; puis une cinquième étape e) selon laquelle on dépose une seconde électrode ou électrode supérieure TE, par exemple en nitrure de titane TiN ou tout autre métal neutre vis-à-vis de l'oxygène, sur la couche M3M4.

La première électrode BE forme une première couche métallique Me1 ; la couche M1O d'oxyde stœchiométrique du premier métal M1 forme une couche d'isolant I ; et la couche M2N de nitrure du deuxième métal M2, la couche M3M4 d'alliage binaire des troisième et quatrième métaux M3, M4 et la seconde électrode TE forment une seconde couche métallique Me2.

Les premier, deuxième, troisième et quatrième métaux M1, M2, M3 et M4 sont tels que l'enthalpie libre standard de formation de tout alliage ternaire M3M4O des troisième et quatrième métaux M3, M4 et d'oxygène O, notée $\Delta G_{f,T}^{0}(M3M4O)$, soit strictement inférieure à l'enthalpie libre standard de formation de tout oxyde sous-stœchiométrique M1Oss du premier métal M1, notée $\Delta G_{f,T}^{0}(M1Oss)$, elle-même inférieure ou égale à l'enthalpie libre standard de formation de tout oxynitrure ternaire M2NO du deuxième métal M2, notée $\Delta G_{f,T}^{0}(M2NO)$ :

$$\Delta G_{f,T}^{0}(M3M4O) < \Delta G_{f,T}^{0}(M1Oss) \leq \Delta G_{f,T}^{0}(M2NO)$$

Ainsi, l'empilement 1 représenté à la figure 1b évolue spontanément, à température ambiante ou avec assistance thermique, vers l'empilement 10 représenté à la figure 1c : la couche M1O d'oxyde stœchiométrique du premier métal M1 devient une couche M1Oss d'oxyde sous-stœchiométrique du premier métal M1, et la couche M3M4 d'alliage binaire des troisième et quatrième métaux M3, M4 devient une couche M3M4O d'alliage ternaire des troisième et quatrième métaux M3, M4 et d'oxygène O. Les figures 1b et 1c montrent respectivement le profil schématique en oxygène des empilements 1 et 10 : dans l'empilement 1, l'oxygène se trouve essentiellement dans la couche M1O. Dans l'empilement 10, un gradient d'oxygène s'est formé dans la couche M1Oss, avec une déplétion en oxygène localisée du côté de la première électrode BE. A la limite, le gradient d'oxygène est tel que la couche M1Oss se décompose en une première sous-couche M1 du premier métal M1 du côté de la première électrode, et une deuxième sous-couche M1O d'oxyde stœchiométrique du premier métal M1. Par ailleurs, l'oxygène ayant migré depuis la couche M1O se trouve désormais localisé dans la couche M3M4O.

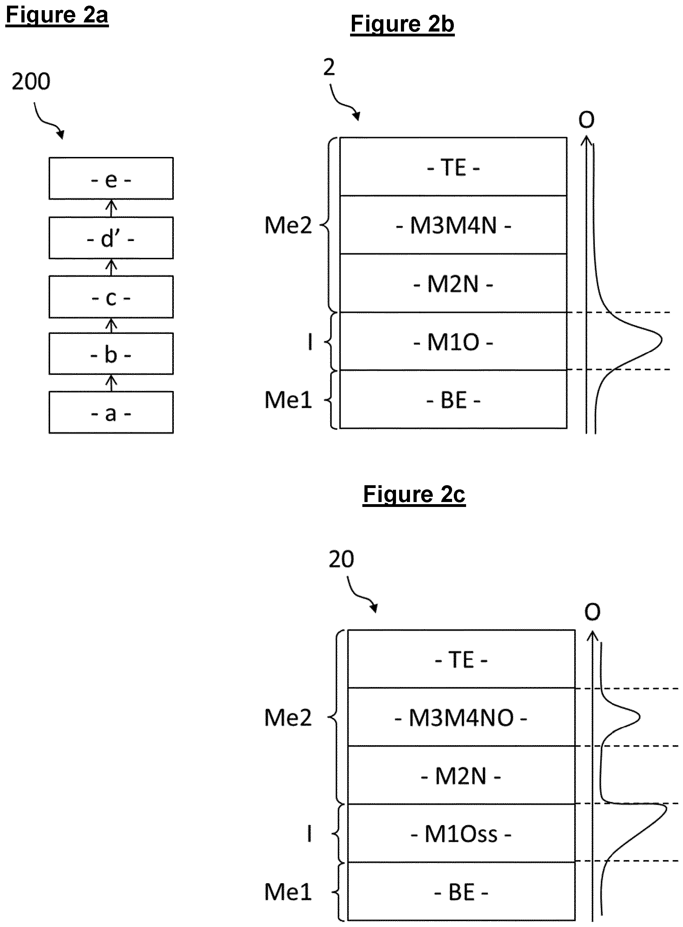

La figure 2a montre schématiquement un diagramme des étapes d'un deuxième procédé de fabrication 200 d'une cellule mémoire résistive à base d'oxyde OxRAM 20 selon un deuxième mode de réalisation de l'invention. La figure 2b montre schématiquement la cellule mémoire résistive à base d'oxyde OxRAM 2 hors équilibre thermodynamique, obtenue de manière transitoire immédiatement après les différentes étapes de dépôt du procédé de la figure 2a. La figure 2c montre schématiquement la cellule mémoire résistive à base d'oxyde OxRAM 20 ayant atteint son équilibre thermodynamique. Les figures 2a, 2b et 2c sont décrites conjointement.

Le deuxième procédé de fabrication 200 est identique au premier procédé de fabrication 100, à l'exception de sa quatrième étape d'), selon laquelle on dépose une couche M3M4N d'un alliage ternaire des troisième et quatrième métaux M3, M4 et d'azote N, sur la couche M2N. Les premier, deuxième, troisième et quatrième métaux M1, M2, M3, M4 sont tels que l'enthalpie libre standard de formation de tout alliage quaternaire M3M4NO des troisième et quatrième métaux M3, M4, d'azote N et d'oxygène O, notée $\Delta G_{f,T}^0(M3M4NO)$, soit strictement inférieure à l'enthalpie libre standard de formation de tout oxyde sous-stœchiométrique M1Oss du premier métal M1, notée $\Delta G_{f,T}^0(M1Oss)$, elle-même inférieure ou égale à l'enthalpie libre standard de formation de tout oxynitrure ternaire M2NO du deuxième métal M2, notée $\Delta G_{f,T}^0(M2NO)$ :

$$\Delta G_{f,T}^0(M3M4NO) < \Delta G_{f,T}^0(M1Oss) \le \Delta G_{f,T}^0(M2NO)$$

L'empilement 2 représenté à la figure 2b évolue spontanément, à température ambiante ou avec assistance thermique, vers l'empilement 20 représenté à la figure 2c, de manière analogue à l'évolution précédemment décrite de l'empilement 1 de la figure 1b vers l'empilement 10 de la figure 1c, la couche M3M4N d'alliage ternaire des troisième et quatrième métaux M3, M4 et d'azote N devenant une couche M3M4NO d'alliage quaternaire des troisième et quatrième métaux M3, M4, d'azote N et d'oxygène O. Les figures 2b et 2c montrent respectivement le profil schématique en oxygène des empilements 2 et 20, qui est analogue à celui des empilements 1 et 10 des figures 1b et 1c.

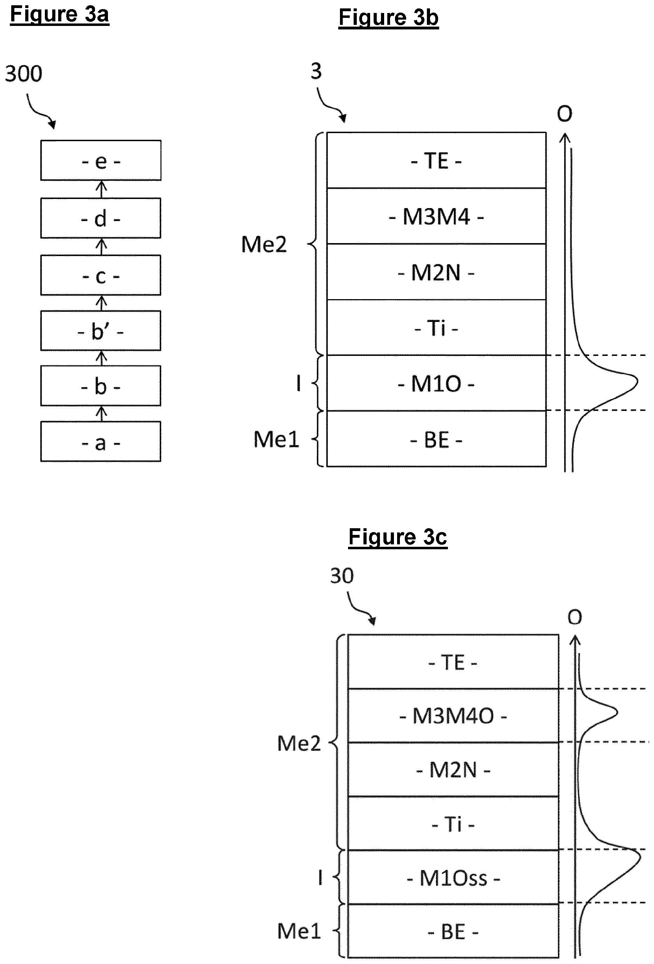

La figure 3a montre schématiquement un diagramme des étapes d'un troisième procédé de fabrication 300 d'une cellule mémoire résistive à base d'oxyde OxRAM 30 selon un troisième mode de réalisation de l'invention. La figure 3b montre schématiquement la cellule mémoire résistive à base d'oxyde OxRAM 3 hors équilibre thermodynamique, obtenue de manière transitoire immédiatement après les différentes étapes de dépôt du procédé 300 de la figure 3a. La figure 3c montre schématiquement la cellule mémoire résistive à base d'oxyde OxRAM 30 ayant atteint son équilibre thermodynamique. Les figures 3a, 3b et 3c sont décrites conjointement.

Le troisième procédé de fabrication 300 est identique au premier procédé de fabrication 100, à l'exception d'une étape supplémentaire b') intercalée entre les étapes b) et c), et selon laquelle on dépose une couche réservoir en titane Ti sur la couche d'isolant M1O d'oxyde stœchiométrique du premier métal M1. La couche M2N du nitrure du deuxième métal est alors déposée non plus sur la couche M1O mais sur la couche réservoir en titane Ti. De même que pour le premier procédé de fabrication, les premier, deuxième, troisième et quatrième métaux M1, M2, M3, M4 sont tels que l'enthalpie libre standard de formation de tout alliage ternaire M3M4O des troisième et quatrième métaux M3, M4 et d'oxygène O, notée $\Delta G_{f,T}^0(M3M4O)$, soit strictement inférieure à l'enthalpie libre standard de formation de tout oxyde sous-stœchiométrique M1Oss du premier métal M1, notée $\Delta G_{f,T}^0(M1Oss)$, elle-même inférieure ou égale à l'enthalpie libre standard de formation de tout oxynitrure ternaire M2NO du deuxième métal M2, notée $\Delta G_{f,T}^0(M2NO)$ :

$$\Delta G_{f,T}^0(M3M4O) < \Delta G_{f,T}^0(M1Oss) \le \Delta G_{f,T}^0(M2NO)$$

L'empilement 3 représenté à la figure 3b évolue spontanément, à température ambiante ou avec assistance thermique, vers l'empilement 30 représenté à la figure 3c, de manière analogue à l'évolution précédemment décrite de l'empilement 1 de la figure 1b vers l'empilement 10 de la figure 1c. Les figures 3b et 3c montrent respectivement le profil schématique en oxygène des empilements 3 et 30, qui est analogue à celui des empilements 1 et 10 des figures 1b et 1c.

Les deuxième et troisième procédés de fabrication 200, 300 représentent chacun une alternative du premier procédé de fabrication 100 : couche M3M4N au lieu de M3M4 pour le deuxième procédé 200 ; couche supplémentaire réservoir en titane Ti pour le troisième procédé 300. Ces deux alternatives sont compatibles entre elles : un procédé de fabrication comportant à la fois l'étape b') de dépôt d'une couche réservoir en titane Ti sur la couche d'isolant M1O, et l'étape d') de dépôt d'une couche M3M4N sur la couche M2N ne sort pas du cadre de l'invention. L'empilement obtenu immédiatement à l'issue de ce procédé de fabrication comporte la seconde électrode TE, sur la couche M3M4N, sur la couche M2N, sur la couche réservoir en Ti, sur la couche M1O, sur la première électrode BE. Cet empilement évolue spontanément, à température ambiante ou avec assistance thermique, vers un empilement dans lequel la couche M3M4N devient la couche M3M4NO et la couche M1O devient la couche M1Oss, de manière analogue aux évolutions précédemment décrites.

Plusieurs exemples particuliers de réalisation sont à présent décrits. Selon un premier exemple, le premier métal M1 est de l'hafnium Hf, les deuxième et troisième métaux M2, M3 sont du titane Ti et le quatrième métal M4 est de l'aluminium Al. La couche M1O est une couche de dioxyde d'hafnium $HfO_2$ stœchiométrique ; la couche M1Oss est une couche de dioxyde d'hafnium $HfO_{z<2}$ sous-stœchiométrique. La couche M2N est une couche de nitrure de titane TiN. La couche M3M4 est une couche de titane-aluminium TiAl; la couche M3M4O est une couche TiAlO d'alliage de titane, aluminium et oxygène.

Selon un deuxième exemple, les premier et deuxième métaux M1, M2 sont de l'hafnium Hf, le troisième métal est du titane Ti et le quatrième métal est de l'aluminium Al. La couche M1O est une couche de dioxyde d'hafnium $HfO_2$ stœchiométrique ; la couche M1Oss est une couche de dioxyde d'hafnium $HfO_{z<2}$ sous-stœchiométrique. La couche M2N est une couche de nitrure d'hafnium HfN. La couche M3M4 est une couche de titane-aluminium TiAl ; la couche M3M4O est une couche TiAlO d'alliage de titane, aluminium et oxygène.

Selon un troisième exemple, les premier et deuxième métaux M1, M2 sont du vanadium V, le troisième métal est de l'hafnium Hf et le quatrième métal est du silicium Si. La couche M1O est une couche de pentoxyde de vanadium $V_2O_5$ stœchiométrique ; la couche M1Oss est une couche de pentoxyde de vanadium $V_2O_{z<5}$ sous-stœchiométrique. La couche M2N est une couche de nitrure de vanadium VN. La couche M3M4 est une couche d'hafnium-silicium HfSi ; la couche M3M4O est une couche HfSiO d'alliage d'hafnium, silicium et oxygène.

Selon un quatrième exemple, le premier métal M1 est de l'hafnium Hf, le deuxième métal M2 est du zirconium Zr, le troisième métal est du titane Ti et le quatrième métal est de l'aluminium Al. La couche M1O est une couche de dioxyde d'hafnium $HfO_2$ stœchiométrique; la couche M1Oss est une couche de dioxyde d'hafnium $HfO_{z<2}$ sous-stœchiométrique. La couche M2N est une couche de nitrure de zirconium ZrN. La couche M3M4 est une couche de titane-aluminium TiAl ; la couche M3M4O est une couche TiAlO d'alliage de titane, aluminium et oxygène.

Plus généralement, le quatrième métal M4 est choisi pour avoir une solubilité à l'oxygène inférieure à la solubilité à l'oxygène du troisième métal M3. La couche d'alliage binaire M3M4 ou d'alliage ternaire M3M4N comporte une proportion du troisième métal M3 de (1-x) et une proportion du quatrième métal M4 de x, où x appartient à l'intervalle [1% ; 60%], préférentiellement [5% ; 50%], préférentiellement [10% ; 40%]. Par exemple, x est égal à 30%.

Les premier, deuxième, troisième et quatrième métaux M1, M2, M3 et M4 sont choisis parmi les éléments de transition des groupes 4, 5 et 6 du tableau périodique et les éléments silicium Si et aluminium Al ; les premier et deuxième métaux M1 et M2 étant identiques ou distincts et les deuxième et troisième métaux M2 et M3 étant identiques ou distincts mais les premier, deuxième et troisième métaux M1, M2 et M3 n'étant pas tous identiques ; et les troisième et quatrième métaux M3 et M4 étant distincts. Les premier, deuxième, troisième et quatrième métaux M1, M2, M3 et M4 sont par exemple choisis parmi les éléments hafnium Hf, zirconium Zr, titane Ti, tantale Ta, niobium Nb, vanadium V, tungstène W, molybdène Mo, silicium Si et aluminium Al.

L'oxyde stœchiométrique du premier métal M1 est par exemple du dioxyde d'hafnium $HfO_2$ ou du dioxyde de zirconium $ZrO_2$ ou du dioxyde de titane $TiO_2$ ou du pentoxyde de tantale $Ta_2O_5$ ou du dioxyde de vanadium $VO_2$ ou du pentoxyde de vanadium $V_2O_5$ ou de l'oxyde de tungstène $WO_1$ ou du dioxyde de tungstène $WO_2$ ou du trioxyde de tungstène $WO_3$ ou de l'oxyde d'aluminium $Al_2O_3$ ou du dioxyde de silicium $SiO_2$. L'oxyde sous-stœchiométrique du premier métal M1 est donc par exemple du dioxyde d'hafnium $HfO_{z<2}$ ou du dioxyde de zirconium $ZrO_{z<2}$ ou du dioxyde de titane $TiO_{z<2}$ ou du pentoxyde de tantale $Ta_2O_{z<5}$ ou du dioxyde de vanadium $VO_{z<2}$ ou du pentoxyde de vanadium $V_2O_{z<5}$ ou de l'oxyde de tungstène $WO_{z<1}$ ou du dioxyde de tungstène $WO_{z<2}$ ou du trioxyde de tungstène $WO_{z<3}$ ou de l'oxyde d'aluminium $Al_2O_{z<3}$ ou du dioxyde de silicium $SiO_{z<2}$.

Le nitrure du deuxième métal M2 est du nitrure de titane TiN ou du nitrure de tantale TaN ou du nitrure de zirconium ZrN ou du nitrure d'hafnium HfN ou du nitrure de tungstène WN ou du nitrure de vanadium VN ou du carbonitrure de titane TiCN ou du carbonitrure de tantale TaCN ou du carbonitrure de molybdène MoCN, ou du carbonitrure de tungstène WCN

Selon le premier mode de réalisation, l'alliage binaire M3M4 est par exemple un alliage binaire de :

- titane Ti et aluminium Al, ou

- titane Ti et silicium Si, ou

- zirconium Zr et aluminium Al, ou

- zirconium Zr et silicium Si.

- hafnium Hf et aluminium Al, ou

- hafnium Hf et silicium Si.

L'alliage ternaire M3M4O est donc par exemple un alliage ternaire de :

- titane Ti, aluminium Al et oxygène O, ou

- titane Ti, silicium Si et oxygène O, ou

- zirconium Zr, aluminium Al et oxygène O, ou

- zirconium Zr, silicium Si et oxygène O, ou

- hafnium Hf, aluminium Al et oxygène O, ou

- hafnium Hf, silicium Si et oxygène O.

Selon le deuxième mode de réalisation, l'alliage ternaire M3M4N est par exemple un alliage ternaire de :

- titane Ti, aluminium Al, et azote N, ou

- titane Ti, silicium Si, et azote N, ou

- zirconium Zr, aluminium Al, et azote N, ou

- zirconium Zr, silicium Si, et azote N, ou

- hafnium Hf, aluminium Al, et azote N, ou

- hafnium Hf, silicium Si et, et azote N.

L'alliage quaternaire M3M4NO est donc par exemple un alliage quaternaire de :

- titane Ti, aluminium Al, azote N et oxygène O, ou

- titane Ti, silicium Si, azote N et oxygène O, ou

- zirconium Zr, aluminium Al, azote N et oxygène O, ou

- zirconium Zr, silicium Si, azote N et oxygène O, ou

- hafnium Hf, aluminium Al, azote N et oxygène O, ou

- hafnium Hf, silicium Si et, azote N oxygène O.

Selon l'un quelconque des modes de réalisation :

- la couche M1O d'oxyde stœchiométrique du premier métal et la couche M1Oss d'oxyde sous-stœchiométrique du premier métal sont d'épaisseur comprise dans l'intervalle [1 nm ; 15 nm] et préférentiellement 10 nm ; et

- la couche M2N de nitrure du deuxième métal est d'épaisseur comprise dans l'intervalle [2 nm ; 20 nm] et préférentiellement 5 nm ;

- la couche d'alliage binaire M3M4 ou ternaire M3M4N, et la couche d'alliage ternaire M3M4O ou quaternaire M3M4NO, sont d'épaisseur comprise dans l'intervalle [1 nm ; 50 nm] et préférentiellement 20 nm.

Naturellement, l'invention n'est pas limitée aux modes de réalisation décrits en référence aux figures et des variantes pourraient être envisagées sans sortir du cadre de l'invention.

**Revendications**

1. Cellule mémoire résistive à base d'oxyde OxRAM comportant une couche d'isolant (I) agencée entre une première couche métallique (Me1) et une seconde couche métallique (Me2):

   - la première couche métallique (Me1) est une première électrode (BE) ;
   - la couche d'isolant (I) est une couche M1Oss d'un oxyde sous-stœchiométrique d'un premier métal M1, **caractérisée en ce que**:

      - la deuxième couche métallique (Me2) comporte, dans cet ordre depuis la couche d'isolant :

         ◦ une première sous-couche M2N d'un nitrure d'un deuxième métal M2 ;
         ◦ une deuxième sous-couche M3M4O d'un alliage ternaire d'un troisième métal M3, d'un quatrième métal M4 et d'oxygène O, ou M3M4NO d'un alliage quaternaire du troisième métal M3, du quatrième métal M4, d'azote N et d'oxygène O ;
         ◦ une seconde électrode (TE) ;

   et **en ce que** les premier, deuxième, troisième et quatrième métaux M1, M2, M3 et M4 sont tels que l'enthalpie libre standard de formation de l'alliage ternaire M3M4O, notée $\Delta G_{f,T}^0(M3M4O)$, ou de l'alliage quaternaire M3M4NO, notée $\Delta G_{f,T}^0(M3M4NO)$, soit strictement inférieure à l'enthalpie libre standard de formation de l'oxyde sous-stœchiométrique M1Oss du premier métal M1, notée $\Delta G_{f,T}^0(M1Oss)$, elle-même inférieure ou égale à l'enthalpie libre standard de formation de tout oxynitrure ternaire M2NO du deuxième métal M2, notée $\Delta G_{f,T}^0(M2NO)$ :

$$\Delta G_{f,T}^0(M3M4O) < \Delta G_{f,T}^0(M1Oss) \leq \Delta G_{f,T}^0(M2NO)$$

$$ou\ \Delta G_{f,T}^0(M3M4NO) < \Delta G_{f,T}^0(M1Oss) \leq \Delta G_{f,T}^0(M2NO)$$

2. Cellule mémoire résistive à base d'oxyde OxRAM selon la revendication précédente, **caractérisée en ce qu'**elle comporte en outre une couche réservoir en titane Ti, intercalée entre la couche d'isolant (I) et la première sous-couche M2N du nitrure du deuxième métal M2 de la deuxième couche métallique (Me2).

3. Cellule mémoire résistive à base d'oxyde OxRAM selon l'une quelconque des revendications précédentes, **caractérisée en ce que** le quatrième métal M4 a une solubilité à l'oxygène inférieure à la solubilité à l'oxygène du troisième métal M3.

4. Cellule mémoire résistive à base d'oxyde OxRAM selon l'une quelconque des revendications précédentes, **caractérisée en ce que** les premier, deuxième, troisième et quatrième métaux M1, M2, M3 et M4 sont choisis parmi les éléments de transition des groupes 4, 5 et 6 du tableau périodique et les éléments silicium Si et aluminium Al ; les premier et deuxième métaux M1 et M2 étant identiques ou distincts et les deuxième et troisième métaux M2 et M3 étant identiques ou distincts mais les premier, deuxième et troisième métaux M1, M2 et M3 n'étant pas tous identiques ; et les troisième et quatrième métaux M3 et M4 étant distincts.

5. Cellule mémoire résistive à base d'oxyde OxRAM selon la revendication précédente, **caractérisée en ce que** les premier, deuxième, troisième et quatrième métaux M1, M2, M3 et M4 sont choisis parmi les éléments hafnium Hf, zirconium Zr, titane Ti, tantale Ta, niobium Nb, vanadium V, tungstène W, molybdène Mo, silicium Si et aluminium Al.

6. Cellule mémoire résistive à base d'oxyde OxRAM selon l'une quelconque des revendications précédentes, **caractérisée en ce que** l'oxyde sous-stœchiométrique du premier métal M1 est du dioxyde d'hafnium $HfO_{z<2}$ ou du dioxyde de zirconium $ZrO_{z<2}$ ou du dioxyde de titane $TiO_{z<2}$ ou du pentoxyde de tantale $Ta2O_{z<5}$ ou du dioxyde de vanadium $VO_{z<2}$ ou du pentoxyde de vanadium $V2O_{z<5}$ ou de l'oxyde de tungstène $WO_{z<1}$ ou du dioxyde de tungstène $WO_{z<2}$ ou du trioxyde de tungstène $WO_{z<3}$ ou de l'oxyde d'aluminium $Al2O_{z<3}$ ou du dioxyde de silicium

$SiO_{z<2}$.

7. Cellule mémoire résistive à base d'oxyde OxRAM selon l'une quelconque des revendications précédentes, **caractérisée en ce que** le nitrure du deuxième métal M2 est du nitrure de titane TiN ou du nitrure de tantale TaN ou du nitrure de zirconium ZrN ou du nitrure d'hafnium HfN ou du nitrure de tungstène WN ou du nitrure de vanadium VN ou du carbonitrure de titane TiCN ou du carbonitrure de tantale TaCN ou du carbonitrure de molybdène MoCN, , ou du carbonitrure de tungstène WCN

8. Cellule mémoire résistive à base d'oxyde OxRAM selon l'une quelconque des revendications précédentes, **caractérisée en ce que** l'alliage ternaire M3M4O est un alliage ternaire de :

- titane Ti, aluminium Al et oxygène O, ou
- titane Ti, silicium Si et oxygène O, ou
- zirconium Zr, aluminium Al et oxygène O, ou
- zirconium Zr, silicium Si et oxygène O, ou
- hafnium Hf, aluminium Al et oxygène O, ou
- hafnium Hf, silicium Si et oxygène O ;

et **en ce que** l'alliage quaternaire M3M4NO est un alliage quaternaire de :

- titane Ti, aluminium Al, azote N et oxygène O, ou
- titane Ti, silicium Si, azote N et oxygène O, ou
- zirconium Zr, aluminium Al, azote N et oxygène O, ou
- zirconium Zr, silicium Si, azote N et oxygène O, ou
- hafnium Hf, aluminium Al, azote N et oxygène O, ou
- hafnium Hf, silicium Si et, azote N oxygène O.

9. Cellule mémoire résistive à base d'oxyde OxRAM selon l'une quelconque des revendications précédentes, **caractérisée en ce que** dans la deuxième sous-couche d'alliage ternaire M3M4O ou d'alliage quaternaire M3M4NO comporte une proportion du troisième métal M3 de (1-x) et une proportion du quatrième métal M4 de x, où x appartient à l'intervalle [1% ; 60%], préférentiellement [5% ; 50%], préférentiellement [10% ; 40%].

10. Cellule mémoire résistive à base d'oxyde OxRAM selon la revendication précédente, **caractérisée en ce que** x est égal à 30%.

11. Cellule mémoire résistive à base d'oxyde OxRAM selon l'une quelconque des revendications précédentes, **caractérisée en ce que** la couche M1Oss d'oxyde sous-stœchiométrique du premier métal est d'épaisseur comprise dans l'intervalle [1 nm ; 15 nm] et préférentiellement 10 nm.

12. Cellule mémoire résistive à base d'oxyde OxRAM selon l'une quelconque des revendications précédentes, **caractérisée en ce que** la première sous-couche M2N de nitrure du deuxième métal est d'épaisseur comprise dans l'intervalle [2 nm ; 20 nm] et préférentiellement 5 nm.

13. Cellule mémoire résistive à base d'oxyde OxRAM selon l'une quelconque des revendications précédentes, **caractérisée en ce que** la deuxième sous-couche d'alliage ternaire M3M4O ou d'alliage quaternaire M3M4NO est d'épaisseur comprise dans l'intervalle [1 nm ; 50 nm] et préférentiellement 20 nm.

14. Procédé de fabrication d'une cellule mémoire résistive à base d'oxyde OxRAM selon l'une quelconque des revendications précédentes, le procédé de fabrication comportant les étapes suivantes, dans cet ordre :

a) déposer une première électrode (BE) ;
b) déposer une couche M1O d'un oxyde stœchiométrique d'un premier métal M1 ;
c) déposer une couche M2N d'un nitrure d'un deuxième métal M2 ;
d) déposer une couche M3M4 d'un alliage binaire d'un troisième métal M3 et d'un quatrième métal M4, ou M3M4N d'un alliage ternaire du troisième métal M3, du quatrième métal M4 et d'azote N ;
e) déposer une seconde électrode (TE) ;

les premier, deuxième, troisième et quatrième métaux M1, M2, M3 et M4 étant choisis de manière que l'enthalpie libre standard de formation de tout alliage ternaire M3M4O des troisième et quatrième métaux M3, M4 et d'oxygène O, notée $\Delta G_{f,T}^0(M3M4O)$, ou de tout alliage quaternaire M3M4NO des troisième et quatrième métaux M3, M4, d'azote N et d'oxygène O, notée $\Delta G_{f,T}^0(M3M4NO)$, soit strictement inférieure à l'enthalpie libre standard de formation de tout oxyde sous-stœchiométrique M1Oss du premier métal M1, notée $\Delta G_{f,T}^0(M1Oss)$, elle-même inférieure ou égale à l'enthalpie libre standard de formation de tout oxynitrure ternaire M2NO du deuxième métal M2, notée $\Delta G_{f,T}^0(M2NO)$ :

$$\Delta G_{f,T}^0(M3M4O) < \Delta G_{f,T}^0(M1Oss) \leq \Delta G_{f,T}^0(M2NO)$$

$$ou\ \Delta G_{f,T}^0(M3M4NO) < \Delta G_{f,T}^0(M1Oss) \leq \Delta G_{f,T}^0(M2NO)$$

**Patentansprüche**

1. Ohmsche Speicherzelle auf Oxidbasis OxRAM, umfassend eine Isolationsschicht (I), die zwischen einer ersten Metallschicht (Me1) und einer zweiten Metallschicht (Me2) angeordnet ist:

 - Wobei die erste Metallschicht (Me1) eine erste Elektrode (BE) ist;
 - Und wobei die Isolationsschicht (I) eine Schicht M1Oss eines unterstöchiometrischen Oxids eines ersten Metalls M1 ist, **dadurch gekennzeichnet, dass**:
 - die zweite Metallschicht (Me2) in dieser Reihenfolge ab der Isolationsschicht umfasst:

  ◦ eine erste Teilschicht M2N eines Nitrids eines zweiten Metalls M2;
  ◦ eine zweite Teilschicht M3M4O einer ternären Legierung eines dritten Metalls M3, eines vierten Metalls M4 und eines Oxids O oder M3M4NO einer quaternären Legierung des dritten Metalls M3, des vierten Metalls M4, Stickstoffs N und Sauerstoffs O;
  ◦ eine zweite Elektrode (TE);
  und dass das erste, zweite, dritte und vierte Metall M1, M2, M3 und M4 derart sind, dass die freie Bildungsstandard-Enthalpie der ternären Legierung M3M4O, bezeichnet mit $\Delta G_{f,T}^0$ (M3M4O), oder die quaternäre Legierung M3M4NO, bezeichnet mit $\Delta G_{f,T}^0$ (M3M4NO), strikt geringer ist als die freie Bildungsstandard-Enthalpie des unterstöchiometrischen Oxids M1Oss des ersten Metalls M1, bezeichnet mit $\Delta G_{f,T}^0$ (M1Oss), die selbst niedriger als oder gleich der freien Bildungsstandard-Enthalpie jedes ternären Oxinitrids M2NO des zweiten Metalls M2, bezeichnet mit $\Delta G_{f,T}^0$ (M2NO):

$$\Delta G_{f,T}^0 \text{(M3M4O)} < \Delta G_{f,T}^0 \text{(M1Oss)} \leq \Delta G_{f,T}^0 \text{(M2NO)}$$

$$\text{oder } \Delta G_{f,T}^0 \text{(M3M4NO)} < \Delta G_{f,T}^0 \text{(M1Oss)} \leq \Delta G_{f,T}^0 \text{(M2NO)}.$$

2. Ohmsche Speicherzelle auf Oxidbasis OxRAM gemäß dem voranstehenden Anspruch, **dadurch gekennzeichnet, dass** sie darüber hinaus eine Speicherschicht aus Ti umfasst, die zwischen der Isolationsschicht (I) und der ersten Teilschicht M2N des Nitrids des zweiten Metalls M2 der zweiten Metallschicht (Me2) zwischengeschaltet ist.

3. Ohmsche Speicherzelle auf Oxidbasis OxRAM gemäß irgendeinem der voranstehenden Ansprüche, **dadurch ge-**

**kennzeichnet, dass** das vierte Metall M4 eine Löslichkeit gegenüber Sauerstoff aufweist, die geringer ist als die Löslichkeit gegenüber Sauerstoff des dritten Metalls M3.

4. Ohmsche Speicherzelle auf Oxidbasis OxRAM gemäß irgendeinem der voranstehenden Ansprüche, **dadurch gekennzeichnet, dass** das erste, zweite, dritte und vierte Metall M1, M2, M3 und M4 aus den Übergangselementen der Gruppen 4, 5 und 6 der Periodentabelle und den Elementen Silizium Si und Aluminium Al ausgewählt sind; wobei das erste und zweite Metall M1 und M2 identisch oder unterschiedlich sind und das zweite und dritte Metall M2 und M3 identisch oder unterschiedlich sind, aber wobei das erste, zweite und dritte Metall M1, M2 und M3 nicht alle identisch sind; und das dritte und vierte Metall M3 und M4 unterschiedlich sind.

5. Ohmsche Speicherzelle auf Oxidbasis OxRAM gemäß dem voranstehenden Anspruch, **dadurch gekennzeichnet, dass** das erste, zweite, dritte und vierte Metall M1, M2, M3 und M4 aus den Elementen Hafnium Hf, Zirkonium Zr, Titan Ti, Tantal Ta, Niobium Nb, Vanadium V, Wolfram W, Molybdäne Mo, Silizium Si und Aluminium Al ausgewählt sind.

6. Ohmsche Speicherzelle auf Oxidbasis OxRAM gemäß irgendeinem der voranstehenden Ansprüche, **dadurch gekennzeichnet, dass** das unterstöchiometrische Oxid des ersten Metalls M1 Hafniumdioxid $HfO_{z<2}$ oder Zirkoniumdioxid $ZrO_{z<2}$ oder Titandioxid $TiO_{z<2}$ oder Tantalpentoxid $Ta2O_{z<5}$ oder Vandiumoxid $VO_{z<2}$ oder Vanadiumpentoxid $V2O_{z<5}$ oder Wolframoxid $WO_{z<1}$ oder Wolframdioxid $WO_{z<2}$ oder Wolframtrioxid $WO_{z<3}$ oder Aluminiumoxid $Al2O_{z<3}$ oder Siliziumdioxid $SiO_{z<2}$ ist.

7. Ohmsche Speicherzelle auf Oxidbasis OxRAM gemäß irgendeinem der voranstehenden Ansprüche, **dadurch gekennzeichnet, dass** das Nitrid des zweiten Metalls M2 Titannitrid TiN oder Tantalnitrid TaN oder Zirconiumnitrid ZrN oder Hafniumnitrid HfN oder Wolframnitrid WN oder Vanadiumnitrid VN oder Titan-Kohlenstoffnitrid TiCN oder Tantal-Kohlenstoffnitrid TaCN oder Molybdän-Kohlenstoffnitrid MoCN oder Wolfram-Kohlenstoffnitrid WCN ist.

8. Ohmsche Speicherzelle auf Oxidbasis OxRAM gemäß irgendeinem der voranstehenden Ansprüche, **dadurch gekennzeichnet, dass** die ternäre Legierung M3M4O eine ternäre Legierung ist aus:

   - Titan Ti, Aluminium Al und Sauerstoff O oder
   - Titan Ti, Silizium Si und Sauerstoff O oder
   - Zirkonium Zr, Aluminium Al und Sauerstoff O oder
   - Zirkonium Zr, Silizium Si und Sauerstoff O oder
   - Hafnium Hf, Aluminium Al und Sauerstoff O oder
   - Hafnium Hf, Silizium Si und Sauerstoff O;

   und dass die quaternäre Legierung M3M4NO eine quaternäre Legierung ist aus:

   - Titan Ti, Aluminium Al, Stickstoff N und Sauerstoff O oder
   - Titan Ti, Silizium Si, Stickstoff N und Sauerstoff O oder
   - Zirkonium Zr, Aluminium Al, Stickstoff N und Sauerstoff O oder
   - Zirkonium Zr, Silizium Si, Stickstoff N und Sauerstoff O oder
   - Hafnium Hf, Aluminium Al, Stickstoff N und Sauerstoff O oder
   - Hafnium Hf, Silizium Si und Stickstoff N, Sauerstoff O.

9. Ohmsche Speicherzelle auf Oxidbasis OxRAM gemäß irgendeinem der voranstehenden Ansprüche, **dadurch gekennzeichnet, dass** die zweite ternäre Legierungs-Teilschicht M3M4O oder quaternäre Legierung M3M4NO einen Anteil des dritten Metalls M3 aus (1-x) und einen Anteil des vierten Metalls M4 von x umfasst, wobei x zu dem Intervall [1 %; 60 %], bevorzugt [5 %; 50 %], bevorzugt [10 %; 40 %] gehört.

10. Ohmsche Speicherzelle auf Oxidbasis OxRAM gemäß dem voranstehenden Anspruch, **dadurch gekennzeichnet, dass** x gleich 30 % ist.

11. Ohmsche Speicherzelle auf Oxidbasis OxRAM gemäß irgendeinem der voranstehenden Ansprüche, **dadurch gekennzeichnet, dass** die unterstöchiometrische Oxidschicht M1Oss des ersten Metalls eine Dicke aufweist, die in dem Intervall [1 nm; 15 nm] inbegriffen ist und bevorzugt 10 nm beträgt.

12. Ohmsche Speicherzelle auf Oxidbasis OxRAM gemäß irgendeinem der voranstehenden Ansprüche, **dadurch ge-**

**kennzeichnet, dass** die erste Teilschicht M2N aus Nitrid des zweiten Metalls eine Dicke aufweist, die in dem Intervall [2 nm; 20 nm] inbegriffen ist und bevorzugt 5 nm beträgt.

13. Ohmsche Speicherzelle auf Oxidbasis OxRAM gemäß irgendeinem der voranstehenden Ansprüche, **dadurch gekennzeichnet, dass** die zweite ternäre Teil-Legierungsschicht M3M4O oder quaternäre Legierungsschicht M3M4NO eine Dicke aufweist, die in dem Intervall [1 nm; 50 nm] inbegriffen ist und bevorzugt 20 nm beträgt.

14. Herstellungsverfahren einer ohmschen Speicherzelle auf Oxidbasis OxRAM gemäß irgendeinem der voranstehenden Ansprüche, wobei das Herstellungsverfahren die folgenden Schritte in dieser Reihenfolge umfasst:

   a) Aufbringen einer ersten Elektrode (BE);
   b) Aufbringen einer Schicht M1O aus einem stöchiometrischen Oxid eines ersten Metalls M1;
   c) Aufbringen einer Schicht M2N eines Nitrids eines zweiten Metalls M2;
   d) Aufbringen einer Schicht M3M4 einer binären Legierung eines dritten Metalls M3 und eines vierten Metalls M4 oder M3M4N einer ternären Legierung des dritten Metalls M3, des vierten Metalls M4 und von Stickstoff N;
   e) Aufbringen einer zweiten Elektrode (TE);

   wobei das erste, zweite, dritte und vierte Metall M1, M2, M3 und M4 derart ausgewählt sind, dass die freie Bildungsstandard-Enthalpie jeder ternären Legierung M3M4O des dritten und vierten Metalls M3, M4 und Sauerstoff O, bezeichnet mit $\Delta G_{f,T}^0$ (M3M4O) oder jede quaternäre Legierung M3M4NO des dritten und vierten Metalls M3, M4, Stickstoff N und Sauerstoff O, bezeichnet mit $\Delta G_{f,T}^0$ (M3M4NO) strikt geringer ist als die freie Bildungsstandard-Enthalpie jedes unterstöchiometrischen Oxids M1Oss des ersten Metalls M1, bezeichnet mit $\Delta G_{f,T}^0$ (M1Oss), die wiederum geringer als oder gleich der freien Bildungsstandard-Enthalpie jedes ternären Oxinitrids M2NO des zweiten Metalls M2, bezeichnet mit $\Delta G_{f,T}^0$ (M2NO):

$$\Delta G_{f,T}^0 (M3M4O) < \Delta G_{f,T}^0 (M1Oss) \leq \Delta G_{f,T}^0 (M2NO)$$

$$\text{oder } \Delta G_{f,T}^0 (M3M4NO) < \Delta G_{f,T}^0 (M1Oss) \leq \Delta G_{f,T}^0 (M2NO).$$

**Claims**

1. OxRAM oxide based resistive random access memory cell comprising an insulator layer (I) arranged between a first metal layer (Me1) and a second metal layer (Me2):

   - the first metal layer (Me1) being a first electrode (BE);
   - the insulator layer (I) being a layer M1Oss of a sub-stoichiometric oxide of a first metal M1, **characterised in that**:
   - the second metal layer (Me2) comprises, in this order from the insulator layer:

      ○ a first sub-layer M2N of a nitride of a second metal M2;
      ○ a second sub-layer M3M4O of a ternary alloy of a third metal M3, a fourth metal M4 and oxygen O, or M3M4NO of a quaternary alloy of the third metal M3, the fourth metal M4, nitrogen N and oxygen O;
      o a second electrode (TE);

   and **in that** the first, second, third and fourth metals M1, M2, M3 and M4 are such that the standard free enthalpy of formation of the ternary alloy M3M4O, noted $\Delta G_{f,T}^0(M3M4O)$, or of the quaternary alloy M3M4NO, noted $\Delta G_{f,T}^0(M3M4NO)$, is strictly less than the standard free enthalpy of formation of the sub-stoichiometric oxide M1Oss of the first metal M1, noted $\Delta G_{f,T}^0(M1Oss)$, itself less than or equal to the standard free enthalpy of formation of any ternary oxynitride M2NO of the second metal M2, noted $\Delta G_{f,T}^{0}(M2NO)$ :

$$\Delta G_{f,T}^{0}(M3M4O) < \Delta G_{f,T}^{0}(M1Oss) \leq \Delta G_{f,T}^{0}(M2NO)$$

$$\text{or } \Delta G_{f,T}^{0}(M3M4NO) < \Delta G_{f,T}^{0}(M1Oss) \leq \Delta G_{f,T}^{0}(M2NO).$$

2. OxRAM oxide based resistive random access memory cell according to the preceding claim, **characterised in that** it further comprises a titanium reservoir layer Ti, intercalated between the insulator layer (I) and the first sub-layer M2N of the nitride of the second metal M2 of the second metal layer (Me2).

3. OxRAM oxide based resistive random access memory cell according to any of the preceding claims, **characterised in that** the fourth metal M4 has an oxygen solubility less than the oxygen solubility of the third metal M3.

4. OxRAM oxide based resistive random access memory cell according to any of the preceding claims, **characterised in that** the first, second, third and fourth metals M1, M2, M3 and M4 are selected from transition elements of groups 4, 5 and 6 of the periodic table and the elements silicon Si and aluminium Al; the first and second metals M1 and M2 being identical or distinct and the second and third metals M2 and M3 being identical or distinct but the first, second and third metals M1, M2 and M3 being not all identical; and the third and fourth metals M3 and M4 being distinct.

5. OxRAM oxide based resistive random access memory cell according to the preceding claim, **characterised in that** the first, second, third and fourth metals M1, M2, M3 and M4 are selected from the elements hafnium Hf, zirconium Zr, titanium Ti, tantalum Ta, niobium Nb, vanadium V, tungsten W, molybdenum Mo, silicon Si and aluminium Al.

6. OxRAM oxide based resistive random access memory cell according to any of the preceding claims, **characterised in that** the sub-stoichiometric oxide of the first metal M1 is hafnium dioxide $HfO_{z<2}$ or zirconium dioxide $ZrO_{z<2}$ or titanium dioxide $TiO_{z<2}$ or tantalum pentoxide $Ta2O_{z<5}$ or vanadium dioxide $VO_{z<2}$ or vanadium pentoxide $V2O_{z<5}$ or tungsten oxide $WO_{z<1}$ or tungsten dioxide $WO_{z<2}$ or tungsten trioxide $WO_{z<3}$ or aluminium oxide $Al_2O_{z<3}$ or silicon dioxide $SiO_{z<2}$.

7. OxRAM oxide based resistive random access memory cell according to any of the preceding claims, **characterised in that** the nitride of the second metal M2 is titanium nitride TiN or tantalum nitride TaN or zirconium nitride ZrN or hafnium nitride HfN or tungsten nitride WN or vanadium nitride VN or titanium carbonitride TiCN or tantalum carbonitride TaCN or molybdenum carbonitride MoCN or tungsten carbonitride WCN.

8. OxRAM oxide based resistive random access memory cell according to any of the preceding claims, **characterised in that** the ternary alloy M3M4O is a ternary alloy of:

   - titanium Ti, aluminium Al and oxygen O, or
   - titanium Ti, silicon Si and oxygen O, or
   - zirconium Zr, aluminium Al and oxygen O, or
   - zirconium Zr, silicon Si and oxygen O, or
   - hafnium Hf, aluminium Al and oxygen O, or
   - hafnium Hf, silicon Si and oxygen O;

   and **in that** the quaternary alloy M3M4NO is a quaternary alloy of:

   - titanium Ti, aluminium Al, nitrogen N and oxygen O, or
   - titanium Ti, silicon Si, nitrogen N and oxygen O, or
   - zirconium Zr, aluminium Al, nitrogen N and oxygen O, or
   - zirconium Zr, silicon Si, nitrogen N and oxygen O, or
   - hafnium Hf, aluminium Al, nitrogen N and oxygen O, or
   - hafnium Hf, silicon Si, nitrogen N, oxygen O.

9. OxRAM oxide based resistive random access memory cell according to any of the preceding claims, **characterised**

**in that** in the second sub-layer of ternary alloy M3M4O or quaternary alloy M3M4NO comprises a proportion of the third metal M3 of (1-x) and a proportion of the fourth metal M4 of x, where x belongs to the interval [1%; 60%], preferentially [5%; 50%], more preferentially [10%; 40%].

10. OxRAM oxide based resistive random access memory cell according to the preceding claim, **characterised in that** x is equal to 30%.

11. OxRAM oxide based resistive random access memory cell according to any of the preceding claims, **characterised in that** the layer M1Oss of sub-stoichiometric oxide of the first metal has a thickness comprised in the interval [1 nm; 15 nm] and preferentially 10 nm.

12. OxRAM oxide based resistive random access memory cell according to any of the preceding claims, **characterised in that** the first sub-layer M2N of nitride of the second metal has a thickness comprised in the interval [2 nm; 20 nm] and preferentially 5 nm.

13. OxRAM oxide based resistive random access memory cell according to any of the preceding claims, **characterised in that** the second sub-layer of ternary alloy M3M4O or quaternary alloy M3M4NO has a thickness comprised in the interval [1 nm; 50 nm] and preferentially 20 nm.

14. Method for manufacturing an OxRAM oxide based resistive random access memory cell according to any of the preceding claims, the method comprising the following steps, in this order:

> a) depositing a first electrode (BE);
> b) depositing a layer M1O of a stoichiometric oxide of a first metal M1;
> c) depositing a layer M2N of a nitride of a second metal M2;
> d) depositing a layer M3M4 of a binary alloy of a third metal M3 and a fourth metal M4, or M3M4N of a ternary alloy of the third metal M3, the fourth metal M4 and nitrogen N;
> e) depositing a second electrode (TE);

the first, second, third and fourth metals M1, M2, M3 and M4 being selected in such a way that the standard free enthalpy of formation of any ternary alloy M3M4O of the third and fourth metals M3, M4 and oxygen O, noted $\Delta G_{f,T}^{0}(M3M4O)$, or of any quaternary alloy M3M4NO of the third and fourth metals M3, M4, nitrogen N and oxygen O, noted $\Delta G_{f,T}^{0}(M3M4NO)$, is strictly less than the standard free enthalpy of formation of any sub-stoichiometric oxide M1Oss of the first metal M1, noted $\Delta G_{f,T}^{0}(M1Oss)$, itself less than or equal to the standard free enthalpy of formation of any ternary oxynitride M2NO of the second metal M2, noted $\Delta G_{f,T}^{0}(M2NO)$:

$$\Delta G_{f,T}^{0}(M3M4O) < \Delta G_{f,T}^{0}(M1Oss) \leq \Delta G_{f,T}^{0}(M2NO)$$

$$or\ \Delta G_{f,T}^{0}(M3M4NO) < \Delta G_{f,T}^{0}(M1Oss) \leq \Delta G_{f,T}^{0}(M2NO).$$

## Figure 1a

100

## Figure 1b

1

## Figure 1c

10

## Figure 2a

200

- e -

↑

- d' -

↑

- c -

↑

- b -

↑

- a -

## Figure 2b

2

O

| Me2 { | - TE - |
| | - M3M4N - |
| | - M2N - |
| I { | - M1O - |
| Me1 { | - BE - |

## Figure 2c

20

O

| Me2 { | - TE - |
| | - M3M4NO - |
| | - M2N - |
| I { | - M1Oss - |
| Me1 { | - BE - |

## Figure 3a

300

- e -

↑

- d -

↑

- c -

↑

- b' -

↑

- b -

↑

- a -

## Figure 3b

3

O

| - TE - |
| - M3M4 - |
| - M2N - |
| - Ti - |
| - M1O - |
| - BE - |

Me2

I

Me1

## Figure 3c

30

O

| - TE - |
| - M3M4O - |
| - M2N - |
| - Ti - |
| - M1Oss - |
| - BE - |

Me2

I

Me1

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

• US 2013126821 A1

**Littérature non-brevet citée dans la description**

• **JIYONG WOO et al.** 14th Annual Non-Volatile Memory Technology Symposium (NVMTS). IEEE, 27 Octobre 2014